## Europäisches Patentamt
## European Patent Office
## Office européen des brevets

(19)

(11) Numéro de publication : **0 369 551 B1**

## (12) FASCICULE DE BREVET EUROPEEN

(45) Date de publication du fascicule du brevet :
**09.08.95 Bulletin 95/32**

(51) Int. Cl.$^6$ : **G11C 8/00**

(21) Numéro de dépôt : **89202899.4**

(22) Date de dépôt : **16.11.89**

(54) **Arrangement de cellules de données et structure de réseaux de neurones utilisant un tel arrangement.**

(30) Priorité : **18.11.88 FR 8814999**

(43) Date de publication de la demande :
**23.05.90 Bulletin 90/21**

(45) Mention de la délivrance du brevet :
**09.08.95 Bulletin 95/32**

(84) Etats contractants désignés :
**CH DE FR GB IT LI SE**

(56) Documents cités :
**WO-A-84/00629**
**US-A- 4 287 571**

(73) Titulaire : **LABORATOIRES D'ELECTRONIQUE PHILIPS**
**3, Avenue Descartes**
**F-94450 Limeil-Brévannes (FR)**
(84) **FR**
Titulaire : **Philips Electronics N.V.**
**Groenewoudseweg 1**
**NL-5621 BA Eindhoven (NL)**
(84) **CH DE GB IT LI SE**

(72) Inventeur : **Jousselin, Christian**
**Societe Civile S.P.I.D.**
**156, Boulevard Haussmann**
**F-75008 Paris (FR)**
Inventeur : **Duranton, Marc**
**Societe Civile S.P.I.D.**
**156, Boulevard Haussmann**
**F-75008 Paris (FR)**

(74) Mandataire : **Landousy, Christian et al**
**Société Civile S.P.I.D.**
**156, Boulevard Haussmann**
**F-75008 Paris (FR)**

## Description

L'invention concerne un arrangement de cellules de données qui stocke au moins une matrice de mots de données ordonnés selon des lignes et des colonnes, les lignes ou les colonnes de la matrice étant transposées en des diagonales parallèles pour permettre d'accéder sélectivement par adressage soit des cellules d'une ligne (ou d'une colonne), soit des cellules d'une diagonale de l'arrangement de cellules, la matrice étant distribuée dans l'arrangement pour délivrer/recevoir sur un bus unique, à l'aide de moyens de sélection de mode, des mots de données permutés correspondant soit à une ligne soit à une colonne de la matrice. Un tel arrangement est connu du document WO 84/00629. Le préambule de la revendication 1 se fonde à ce document.

Elle concerne également une structure de réseaux de neurones utilisant un tel arrangement.

Le document WO 84/00629 mentionné ci-dessus traite d'un système de mémoire à accès multidimensionnel. Ce document considère le cas de l'écriture et de la lecture d'un tableau de données à deux dimensions stocké dans une mémoire. Pour permettre l'adressage de mots de données soit selon les lignes soit selon les colonnes du tableau, les données sont rangées dans la mémoire d'une manière particulière, afin que celles-ci puissent être lues/entrées à l'aide d'un bus unique. Pour cela les données sont chargées ligne par ligne, la première ligne chargée correspondant à la première ligne du tableau, la deuxième ligne chargée correspondant à la deuxième ligne du tableau mais après avoir subi une permutation circulaire des données de une case mémoire. Chaque ligne chargée est ainsi décalée de 1 case mémoire par rapport à la précédente et subit en conséquence la permutation circulaire correspondante. Les données qui étaient sur une colonne du tableau se trouvent ainsi disposées selon une diagonale de la mémoire. Les données qui étaient sur une ligne du tableau se trouvent toujours disposées sur la ligne de même rang de la mémoire mais avec une permutation circulaire déterminée. Pour adresser une ligne ou une colonne du tableau qui sont distribuées sur plusieurs colonnes de la mémoire, il est alors nécessaire de déterminer à chaque fois l'adresse vraie en mémoire à l'aide d'un modificateur d'adresses. Les données qui apparaissent avec une certaine permutation sont rétablies dans l'ordre initial à l'aide d'un organe qui opère la rotation des données. Chaque modificateur d'adresses affecté à chaque colonne effectue un calcul d'adresses qui dépend à la fois de la ligne et de la colonne du tableau et de la colonne de la mémoire. De tels calculs nécessitent un matériel important qui présente les inconvénients de retarder le calcul des adresses vraies et d'être trop encombrant pour pouvoir permettre une réalisation intégrée compacte. Le problème posé est donc de réaliser un arrangement du genre qui vient d'être décrit et qui soit intégrable d'une manière compacte et qui ait un fonctionnement rapide.

La solution consiste en un arrangement pour lequel chaque cellule de données est réunie au bus unique à travers des commutateurs, mis en série, propres à chaque mode d'adressage, les commutateurs adressant le mot d'un même mode étant contrôlés par des lignes de commande verticales (respectivement horizontales) commandant des colonnes (respectivement des lignes) et par des lignes de commande diagonales commandant des diagonales, les commutateurs étant commandés en activant les lignes de commande verticales (respectivement les lignes de commande horizontales) et une ligne de commande diagonale ou inversement.

Ainsi avantageusement une ligne unique portant un unique signal de sélection de mode va pouvoir adresser la totalité d'un mot donné en activant à la fois tous les commutateurs concernés. Chaque commutateur peut être formé d'un transistor de sélection. Ceci accroît la compacité et la rapidité de l'arrangement en particulier lorsque celui-ci est réalisé sous forme de circuit intégré.

La matrice de mots de données peut être distribuée dans l'arrangement selon une distribution de type diagonal de sorte qu'une ligne (une colonne) de la matrice étant distribuée en diagonale dans l'arrangement, les autres lignes (autres colonnes) de la matrice soient distribuées parallèlement à cette diagonale.

Les bits constituant les mots de données apparaissent sur le bus dans un ordre qui est différent de celui qu'ils avaient dans les mots de données de la matrice. Pour rétablir cette ordre il faut alors opérer un rangement qui est effectué par un registre à décalage à circulation commandé par un organe de circulation qui décale les données selon le rang adressé de la matrice. Ce rangement des données sur le bus peut également être effectué par un additionneur qui détermine une adresse interne du circuit tampon en ajoutant une valeur prédéterminée propre au rang adressé dans l'arrangement à une adresse externe du circuit tampon.

Lorsqu'on désire distribuer plusieurs matrices de mots de données, il est possible de le faire dans un arrangement bidimensionnel ou dans un arrangement multidimensionnel. Dans ce dernier cas chaque dimension dispose de son mode de sélection. On peut ainsi avoir trois modes de sélection X, Y, Z dans un arrangement tridimensionnel.

L'intérêt pour une réalisation compacte et rapide se manifeste en particulier dans les systèmes qui nécessitent de stocker un grand nombre de tableaux qui peuvent être de grandes dimensions. C'est par exemple le cas des systèmes de réseaux de neurones. Il est nécessaire alors de disposer d'une intégration la plus dense possible avec des vitesses de traitement élevées.

Les réseaux de neurones sont formés d'automates élémentaires connectés entre eux par des synapses auxquelles sont associés des coefficients synaptiques. Un réseau de neurones met en oeuvre des phases de résolution au cours desquelles il détermine des états $V_j$ de neurones de sortie j à partir des états $V_i$ de neurones d'entrée i. Cette phase de résolution s'opère selon :

$$V_j = \sum_i C_{ij} V_i$$

Mais pour s'adapter à une tâche déterminée, le réseau de neurones doit également opérer des phases d'apprentissage. Un tel réseau de neurones est par exemple décrit dans le document : "A chipset for high speed simulation of neural network systems" S.C.J. GARTH IEEE Conference on Neural Networks SAN DIEGO III-443 (1987). Les phases d'apprentissage ont pour objet de modifier les coefficients synaptiques afin que le réseau s'adapte à un problème déterminé.

Pour la mise en oeuvre de l'algorithme d'apprentissage selon la rétropropagation de l'erreur, le réseau de neurones présente une structure en couches. Au cours d'une phase de type "résolution", des états de neurones de sortie sont déterminés à l'aide des coefficients synaptiques stockés dans le réseau. Puis un calculateur hôte compare les états de neurones de sortie déterminés avec les états de neurones attendus. Les erreurs observées sont introduites dans la dernière couche de la structure puis rétropropagées avec un sens de propagation inversé par rapport au sens du mode de résolution. Pour mettre en oeuvre successivement une phase de résolution puis une phase d'apprentissage on utilise les coefficients synaptiques selon une matrice Cij dans la phase de résolution et selon une matrice Cji, transposée de la matrice Cij, dans la phase d'apprentissage comme cela est indiqué dans le document de S.C.J. GARTH.

Ceci nécessite d'effectuer à chaque changement de phases des opérations répétées de chargement des moyens de stockage des coefficients synaptiques par la matrice soit $C_{ij}$ soit la transposée $C_{ji}$.

Ces opérations de chargement nécessitent beaucoup de temps pour être effectuées.

La quantité de calculs à effectuer étant très importante, il est possible d'accroître la rapidité en mettant en oeuvre un traitement parallèle. Ceci nécessite de pouvoir lire/écrire la matrice $C_{ij}$ par blocs de lignes ou de colonnes selon la phase des opérations.

Pour cela on peut chercher à doubler le nombre de moyens de stockage des coefficients synaptiques ou le nombre de bus mais cela nuit à la compacité de la structure et nécessite des moyens de sélection supplémentaires qui retardent néanmoins le fonctionnement.

C'est pourquoi selon l'invention on utilise l'arrangement de cellules de données décrit précédemment.

Dans ce cas l'invention concerne une structure de réseaux de neurones en couches qui comprend :

- des moyens de résolution pour déterminer pour chaque couche des états de neurones de sortie i à partir des états de neurones d'entrée j reliés entre eux par des synapses,
- des moyens de stockage des coefficients synaptiques $C_{ij}$ propres à ces synapses,
- des moyens d'apprentissage et de réactualisation des coefficients synaptiques $C_{ij}$,
- des moyens de stockage des états de neurones, caractérisée en ce que les moyens de stockage des coefficients synaptiques sont constitués d'au moins un arrangement déjà décrit, qui stocke au moins une matrice carrée de coefficients synaptiques $C_{ij}$ qui sont distribués dans au moins une mémoire, celle-ci possédant un double adressage et un bus unique de sorte qu'un mot de coefficients synaptiques relatif soit à une ligne soit à une colonne de la matrice carrée peut être adressé et placé sur le bus unique, afin que la structure de réseaux de neurones opère des phases d'apprentissage soit avec la matrice de coefficients synaptiques soit avec la matrice transposée pour mettre en oeuvre l'algorithme de rétropropagation des erreurs.

Selon une disposition préférentielle les coefficients synaptiques sont distribués dans une mémoire bidimensionnelle selon une distribution de type diagonal de sorte qu'une ligne (une colonne) de la matrice étant distribuée selon une diagonale de la mémoire, les autres lignes (autres colonnes) de la matrice soient distribuées parallèlement à cette diagonale.

Ainsi avantageusement les mots de coefficients synaptiques apparaissent sur le bus dans un ordre prédéterminé et restent néanmoins faciles à exploiter selon l'ordre initial à l'aide d'un registre à décalage à circulation. Pour cela les moyens de stockage des états de neurones comprennent un registre à décalage à circulation qui permet de faire circuler les états de neurones pour apparier chaque état de neurone à son coefficient synaptique.

Ainsi au lieu de remettre les coefficients synaptiques dans leur ordre initial on fait subir aux vecteurs d'états de neurones les permutations circulaires appropriées.

Ces permutations circulaires sont contrôlées par un calculateur d'adresses qui opère la circulation dans le registre à décalage en générant les commandes correspondant au rang du mot de coefficient synaptique adressé.

Cette structure de réseaux de neurones peut constituer un circuit intégré compact opérant un traitement parallèle rapide.

L'invention sera mieux comprise à l'aide des figures suivantes données à titre d'exemple non limitatif qui représentent :

figure 1 : une matrice représentant un exemple de rangement de données selon une disposition classique des données.

figure 2 : une matrice représentant un exemple de disposition des données selon l'art antérieur.

figure 3A : un exemple de réalisation des moyens de rangement des données de sortie.

figure 3B : un autre exemple de réalisation des moyens de rangement des données de sortie.

figure 4 : une structure d'adressage de la matrice de points mémoire à deux dimensions.

figure 5A : une partie d'un circuit de réseaux de neurones selon l'invention.

figures 5B, 5C : deux dispositions des données au cours de phases de résolution et de phases de rétropropagation du gradient.

figures 6A, 6B : une structure d'adressage a trois dimensions.

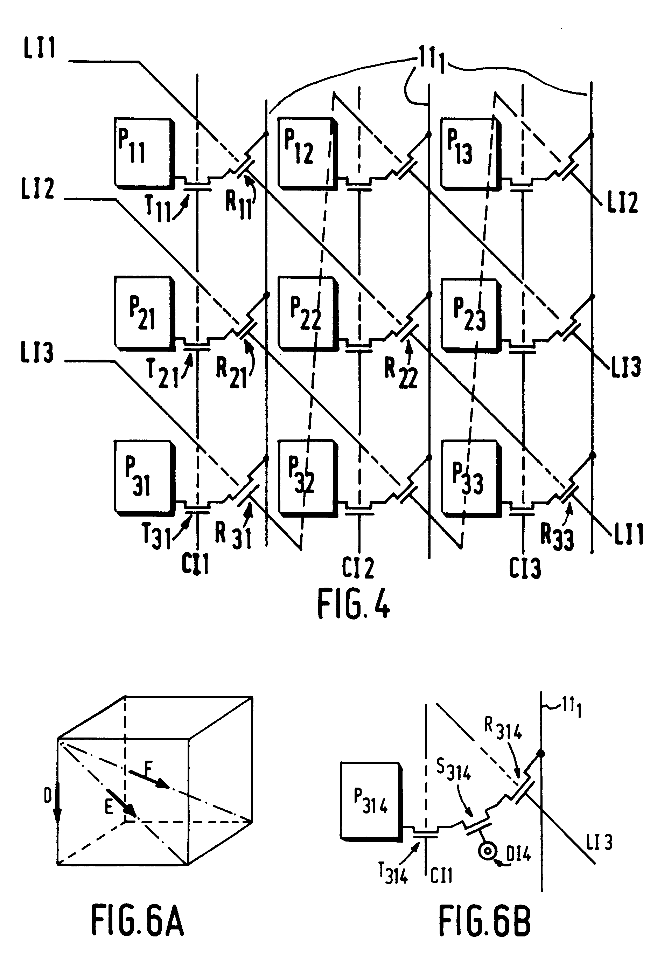

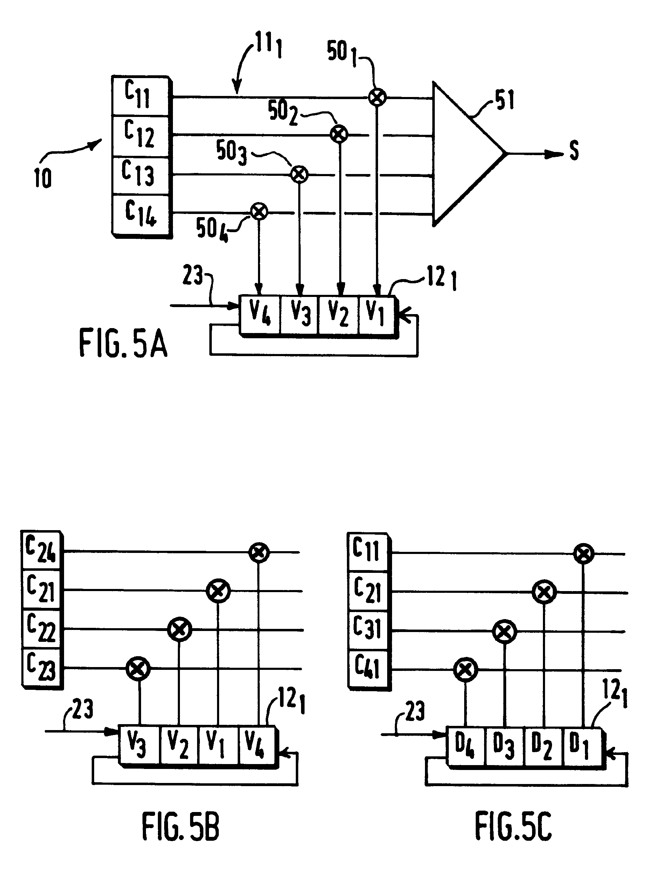

Pour la clarté de l'exposé la description est faite avec un arrangement à deux dimensions de points mémoire. Sa généralisation à trois dimensions est présentée sur les figures 6A et 6B. Des dimensions d'ordre supérieur s'en déduisent sans difficulté.

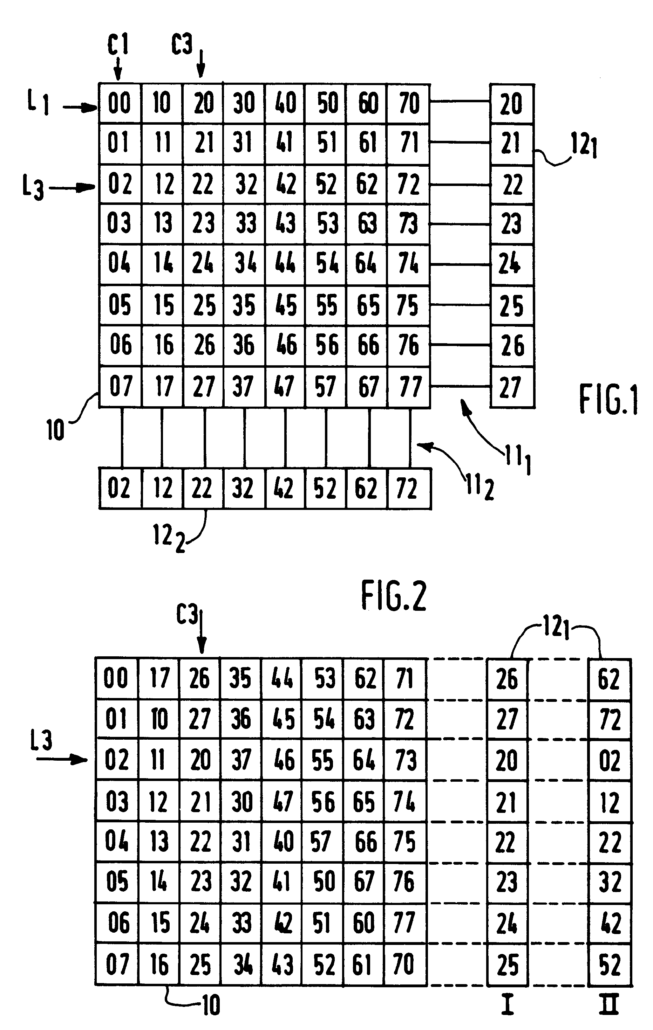

La figure 1 représente une matrice 10 dans laquelle les données sont stockées selon un adressage ligne ou colonne habituel. Pour permettre une explication claire les nombres mis dans chaque case représentent les données stockées. Dans ce cas les lignes/colonnes de la matrice coïncident avec les lignes/colonnes de l'arrangement. Ainsi la ligne L1 contient les données 00 jusqu'à 70, et la colonne C1 contient les données 00 jusqu'à 07. La matrice peut être adressée soit en ligne soit en colonne. Ainsi, si la colonne C3 est adressée les données de la colonne apparaissent sur le bus $11_1$ et peuvent être stockées dans le registre tampon $12_1$. La donnée 20 est dans la case supérieure du registre et la donnée 27 est dans la case inférieure du registre. De même si la ligne L3 est adressée, les données sélectionnées apparaissent sur le bus $11_2$ et peuvent être stockées dans un registre tampon $12_2$ La donnée 02 est dans la case gauche du registre et la donnée 72 est dans la case droite du registre. Ainsi les données des lignes ou des colonnes apparaissent sur des bus différents ce qui nécessite des circuits tampons différents. Si avec une telle disposition on cherche à utiliser un seul circuit tampon ceci ne peut se faire qu'au prix d'interconnexions supplémentaires, certaines assez longues, et avec ajout d'éléments de sélection nombreux.

Selon le document de l'art antérieur, la matrice de mots de données va être disposée dans l'arrangement de cellules de données selon une disposition qui est représentée sur la figure 2. Contrairement au cas précédent il y a lieu de distinguer une ligne/rangée de la matrice et une ligne/rangée de l'arrangement. Sur cette disposition on observe que les données qui étaient sur la première ligne de la figure 1 sont placées sur la diagonale de la matrice carrée de la figure 2. Chaque colonne est alors rangée en mettant la valeur de la première ligne de la figure 1 dans la case de la figure 2 placée sur la diagonale, puis les autres valeurs, par exemple en se déplaçant vers le bas, et lorsque le bas de la matrice est atteint on continue le chargement de la colonne par la case de la première ligne. Selon cet arrangement lorsque la colonne C3 est adressée, les données de la colonne apparaissent sur le bus de sortie puis éventuellement dans le circuit tampon $12_1$ selon le rangement représenté par I. On observe que les données de sortie sont les mêmes que celles de la figure 1 mais avec un rangement différent. Ainsi la donnée 20 apparaît non pas dans la case supérieure mais dans la troisième case du circuit tampon $12_1$. Ainsi chaque donnée est décalée d'un nombre de positions égal au numéro d'ordre de la colonne adressée.

D'une manière analogue lorsque la ligne L3 est adressée les données sélectionnées apparaissent sur le même bus et dans le même circuit tampon $12_1$ que précédemment selon le rangement représenté par II. Le circuit tampon $12_1$ est représenté deux fois sur la figure 2 pour la commodité de l'exposé. On observe également que les données sont les mêmes que lorsque la ligne L3 est adressée selon la disposition de la figure 1 mais là encore avec un rangement différent. Chaque donnée est ainsi décalée d'un nombre de positions égal au numéro d'ordre de la ligne adressée.

L'exemple présenté est une matrice carrée mais l'invention s'applique à des matrices rectangulaires MxN à condition que le bus unique et si nécessaire le circuit tampon unique soient placés sur le côté de la matrice qui délivre le maximum d'éléments binaires. Les éléments mémoires qui possèdent le même adressage en diagonale s'obtiennent par translation de la matrice carrée soit MxM soit NxN inscrite dans la matrice rectangulaire MxN.

La figure 4 représente la structure d'adressage de l'arrangement de cellules de données selon l'invention qui exploite la dispostion de la matrice de données représentée sur la figure 2. Sur la figure 4, les données $M_{ij}$ sont réparties dans les cellules $P_{kl}$ selon l'un ou l'autre des tableaux de répartition suivants exemplifiés jusqu'à l'ordre trois :

$$P11 \leftarrow M11 \qquad P12 \leftarrow M32$$
$$P13 \leftarrow M23$$
$$P21 \leftarrow M21 \qquad P22 \leftarrow M12$$
$$P23 \leftarrow M33$$
$$P31 \leftarrow M31 \qquad P32 \leftarrow M22$$
$$P33 \leftarrow M13$$

ou

$$P11 \leftarrow M11 \qquad P12 \leftarrow M12$$
$$P13 \leftarrow M13$$
$$P21 \leftarrow M23 \qquad P22 \leftarrow M21$$
$$P23 \leftarrow M22$$

P31 ← M32     P32 ← M33
P33 ← M31

où i, j, k, l sont des indices courants et où le signe (←) signifie contient. Dans cet exemple simple correspondant à un arrangement de 3x3 les points P11, P21, P31 d'une même colonne sont sélectionnés par un même signal de sélection CI1 qui opère sur des transistors T11, T21, T31. De même les signaux CI2, CI3 sélectionnent les autres colonnes. Les points mémoires P11, P22, P33 situés sur une même diagonale de l'arrangement (même colonne de la matrice) sont sélectionnés par le signal LI1 qui opère sur les transistors R11, R22, R33. Le signal LI2 opère sur les points P21, P32 et P13. Le signal LI3 opère sur les points P31, P12 et P23. Pour opérer la sélection d'un point il faut rendre actif par exemple soit tous les signaux LI et un des signaux CI ou soit l'inverse. Les données sont délivrées en sortie sur le bus $11_1$. Inversement pour écrire il suffit de présenter les données sur le bus $11_1$, d'effectuer l'adressage et de mettre les points mémoires en état d'écriture.

L'exemple qui vient d'être traité concerne un arrangement à deux dimensions. Les figures 6A et 6B représentent le cas d'un arrangement de cellules à trois dimensions. Dans ce cas selon l'invention (fig. 6A) il est possible d'effectuer l'adressage selon par exemple une direction D correspondant à une dimension de la matrice et une direction diagonale par exemple les directions E ou F. La matrice tridimensionnelle étant repérée par trois indices, la direction D correspond à des points ayant un des indices constant. Lorsque cet adressage dans la direction D concerne uniquement la partie de matrice de la face avant du cube représenté, (un seul indice constant), alors les groupements de cellules sélectionnés correspondent à une colonne de cellules de cette face avant. Lorsque cet adressage dans la direction D concerne la totalité de l'espace tridimensionnel (deux indices constants) alors les groupements de cellules sélectionnés correspondent à une tranche basée sur ladite colonne et qui s'étend dans la direction perpendiculaire à ladite face avant. La matrice tridimensionnelle est représentée pour la commodité de l'explication sous la forme d'un cube mais peut présenter une forme quelconque. En particulier l'arrangement multidimensionnel peut être topologiquement disposé selon une surface (deux dimensions).

Le second adressage va pouvoir être effectué selon les directions diagonales E ou F pour lesquelles soit deux soit trois indices restent identiques entre eux. Cela concerne donc les diagonales elles-mêmes et les lignes de cellules qui leur sont parallèles.

Chacune des dimensions de la matrice possède des moyens d'adressage représentés sur la figure 6B qui se déduisent de la structure de la figure 4. Un seul élément mémoire P314 est représenté. Les transistors T314 (commande $CI_1$), S314 (commande $DI_4$), R314 (commande $LI_3$) permettent d'effectuer l'adressage selon les trois dimensions de la matrice. Un point mémoire par exemple P314 est sélectionné en rendant actives par exemple toutes les commandes CI et DI et seulement la commande $LI_3$. En effet pour activer une cellule quelconque il faut rendre active la totalité de l'adressage selon deux dimensions de la matrice et selon l'autre dimension seulement la commande qui concerne ladite cellule.

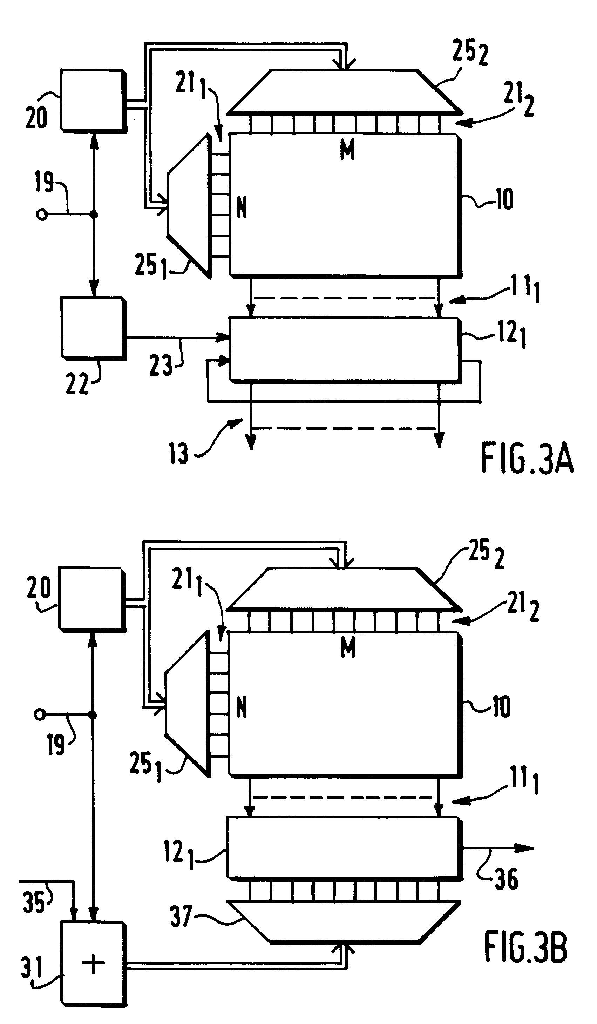

Les figures 3A et 3B représentent une matrice MxN 10 munie d'un bus unique $11_1$ réuni à un circuit tampon $12_1$ qui peut stocker des tranches de M bits. La figure 3A représente une première variante de réalisation des moyens de rangement des données de sortie. Pour cela, à l'aide d'une commande externe 19, un générateur 20 délivre des adresses qui déterminent l'adressage ligne $21_1$ et l'adressage colonne $21_2$ respectivement à l'aide de décodeurs $25_1$ et $25_2$. Cette même commande 19 arrive à un organe de circulation 22 qui selon le rang de l'adresse délivrée, soit ligne soit colonne, délivre une commande de circulation 23 au circuit tampon $12_1$ constitué d'un registre à décalage bouclé sur lui-même. Ainsi les données qui ont été lues à l'aide de l'adressage opéré puis stockées dans le circuit tampon $12_1$ sont mises dans l'ordre souhaité par cette opération avant d'être délivrées sur le bus 13.

La figure 3A permet de sortir les données en parallèle. Il peut être intéressant de pouvoir les sortir en série selon le rangement désiré. Pour cela selon la figure 3B la mise en ordre des données de sortie se fait directement à l'aide d'un décodage d'adresses. Pour cela la commande 19 de l'adressage de la mémoire 10 arrive sur un additionneur 31 qui reçoit également une adresse externe 35 destinée à lire le circuit tampon $12_1$ qui dans ce cas n'est plus un registre à décalage bouclé mais une ligne de points mémoire réunis à une sortie série unique 36. A l'adresse 35 est additionnée une valeur contenue dans la commande 19 qui dépend du rang de la ligne ou de la colonne adressée dans la mémoire 10. L'additionneur est réuni à un décodeur qui délivre l'adresse interne du point mémoire désiré dans le circuit tampon $12_1$. L'adresse externe 35 peut provenir d'un dispositif externe ou d'un compteur qui détermine les adresses pour la lecture du circuit tampon $12_1$.

La figure 5A représente une partie d'un circuit de réseau de neurones traitant un exemple simplifié dans le cas d'un arrangement à deux dimensions. Pour un neurone 1, l'arrangement 10 délivre sur son bus les quatre coefficients synaptiques $C_{11}$, $C_{12}$, $C_{13}$, $C_{14}$ qui arrivent sur des multiplieurs $50_1$, $50_2$, $50_3$, $50_4$ qui reçoivent respectivement les états de neurones $V_1$, $V_2$, $V_3$, $V_4$ qui sont stockés dans le registre à décalage $12_1$ qui constitue dans ce cas la mémoire d'états de neurones. Ces multiplieurs sont réunis à un arbre d'additionneurs 51 qui délivre un résultat S tel que :

$$S = C_{11}.V_1 + C_{12}.V_2 + C_{13}.V_3 + C_{14}.V_4.$$

Pour un neurone 2 l'arrangement va délivrer les coefficients synaptiques avec un rangement différent tel que représenté sur la figure 5B. Avant d'effectuer le calcul pour la phase de résolution, le registre à décalage $12_1$ fait circuler les états de neurones pour apparier correctement chaque état de neurone à son coefficient synaptique. Le coefficient synaptique $C_{23}$ est apparié avec l'état $V_3$, le coefficient synaptique $C_{22}$ est apparié avec l'état $V_2$ et ainsi de suite.

La figure 5C concerne la phase d'apprentissage. En effet dans ce cas les coefficients synaptiques sont lus selon la matrice transposée : $C_{11}$, $C_{21}$, $C_{31}$, $C_{41}$. Dans ce cas le registre $12_1$ contient non pas les états de neurones mais les erreurs $D_1$, $D_2$, $D_3$, $D_4$ afin de mettre en oeuvre l'algorithme de rétropropagation des erreurs. Les mêmes mécanismes de circulation sont mis en oeuvre pour apparier les données. Ainsi le registre habituel qui stocke les états de neurones est transformé en un registre à décalage à circulation pour pouvoir s'adapter aux mots de coefficients synaptiques permutés délivrés par l'arrangement.

Mais le mécanisme de circulation peut ne pas être effectué par le registre à décalage, les coefficients étant mémorisés dans des registres temporaires chargés à partir de multiplexeurs à N voies (pour N coefficients synaptiques) qui rétablissent l'ordre correct des coefficients.

Dans les cas où l'on ne fait pas un accès aléatoire des neurones mais un accès séquentiel et dans l'ordre : neurone 1, puis 2, puis 3 etc..., après chaque évaluation de neurones, on opère un décalage dans le registre à décalage contenant soit les états de neurones soit les erreurs, et ainsi ces termes sont toujours en correspondance avec les coefficients synaptiques qui les pondèrent. Au bout de N calculs, on retombe dans la position initiale de départ.

Dans un circuit où les états sont codés sur m bits, et où les multiplieurs font aussi des multiplications par des termes de m bits, le registre à décalage est constitué de m registres à décalages identiques, chacun portant un des poids de la représentation des états.

Dans un circuit où les états sont codés sur m bits, et où les multiplieurs font des multiplications sur 1 bit (avec des portes ET ou OU-exclusif par exemple), il faut m cycles pour pouvoir calculer la somme pondérée pour un neurone. Dans ce cas le registre à décalage comporte N * m positions et il effectue un décalage après chaque calcul de bit.

## Revendications

1. Arrangement de cellules (P) de données qui stocke au moins une matrice de mots de données (M) ordonnés selon des lignes et des colonnes, les lignes ou les colonnes de la matrice étant transposées en des diagonales parallèles pour permettre d'accéder sélectivement par adressage soit des cellules d'une ligne ou d'une colonne, soit des cellules d'une diagonale de l'arrangement de cellules, la matrice étant distribuée dans l'arrangement pour délivrer/recevoir sur un bus unique ($11_1$), à l'aide de moyens (LI, CI) de sélection de mode, des mots de données permutés correspondant soit à une ligne soit à une colonne de la matrice, caractérisé en ce que chaque cellule de données (P11 - P33) est réunie au bus unique ($11_1$) à travers des commutateurs (R11, T11), mis en série, propres à chaque mode d'adressage, les commutateurs adressant le mot d'un même mode étant contrôlés par des lignes (CI) de commande verticales, respectivement horizontales, commandant des colonnes, respectivement des lignes, et par des lignes (LI) de commande diagonales commandant des diagonales, les commutateurs étant commandés en activant les lignes de commande verticales, respectivement les lignes de commande horizontales, et une ligne de commande diagonale ou inversement.

2. Arrangement selon la revendication 1 caractérisé en ce que chaque commutateur comprend un transistor de sélection (T11, R11).

3. Arrangement selon une des revendications 1 ou 2 caractérisé en ce que la matrice de mots de données est distribuée dans l'arrangement selon une distribution de type diagonal de sorte qu'une ligne (une colonne) de la matrice étant distribuée en diagonale dans l'arrangement, les autres lignes (autres colonnes) de la matrice soient distribuées parallèlement à cette diagonale.

4. Arrangement selon une des revendications 1 à 3 caractérisé en ce que le rangement des données d'un mot sur le bus (13) est effectué par un registre à décalage à circulation ($12_1$) commandé par un organe de circulation (22) qui décale les données selon le rang adressé de la matrice.

5. Arrangement selon une des revendications 1 à 4 caractérisé en ce que le rangement des données d'un mot sur le bus (36) est effectué par un additionneur (31) qui détermine une adresse interne du circuit tampon ($12_1$) en ajoutant une valeur prédéterminée, propre au rang adressé dans l'arrangement, à une adresse externe (35) du circuit tampon.

6. Arrangement selon une des revendications 1 à 5 caractérisé en ce que plusieurs matrices de mots de données sont distribuées dans l'arrangement selon plusieurs dimensions (D, E, F) correspondant à plusieurs modes de sélection.

7. Arrangement selon une des revendications 1 à 6 réalisé sous forme de circuit intégré.

8. Structure de réseaux de neurones en couches qui comprend :
   - des moyens de résolution (50, 51) pour déterminer pour chaque couche des états de neurones de sortie i à partir des états de neurones d'entrée j reliées entre eux par des synapses,
   - une mémoire (10) comprenant des moyens de stockage des coefficients synaptiques $C_{ij}$ propres à ces synapses,
   - des moyens d'apprentissage et de réactualisation des coefficients synaptiques $C_{ij}$,
   - des moyens de stockage ($12_1$) des états de neurones,

   caractérisé en ce que la mémoire (10) est constitué d'au moins un arrangement de cellules selon une des revendications 1 à 2, qui stocke au moins une matrice carrée de coefficients synaptiques $C_{ij}$ qui sont distribués dans au moins l'un des arrangements de cellules celui-ci possédant un double adressage à l'aide du moyen (LI,CI) de sélection de mode et du bus unique ($11_1$) de sorte qu'un mot de coefficients synaptiques relatif soit à une ligne soit à une colonne de la matrice carrée peut être adressé et placé sur le bus unique ($11_1$), afin que la structure de réseaux de neurones opère des phases d'apprentissage soit avec la matrice de coefficients synaptiques soit avec la matrice transposée pour mettre en oeuvre l'algorithme de rétropropagation des erreurs.

9. Structure de réseaux de neurones selon la revendication 8 caractérisée en ce que les coefficients synaptiques sont bidimensionnellement distribués dans la mémoire (10) selon une distribution de type diagonal de sorte qu'une ligne (une colonne) de la matrice étant distribuée en diagonale dans la mémoire, les autres lignes (autres colonnes) de la matrice soient distribuées parallèlement à cette diagonale.

10. Structure de réseaux de neurones selon une des revendications 7 ou 9 caractérisée en ce que les moyens de stockage ($12_1$) des états de neurones comprennent un registre à décalage à circulation qui permet de faire circuler les états de neurones pour apparier chaque état de neurone à son coefficient synaptique.

11. Structure de réseaux de neurones selon la revendication 10 caractérisée en ce qu'elle comprend un calculateur d'adresses (22) qui opère la circulation dans le registre à décalage en générant les commandes correspondant au rang du mot de coefficients synaptiques adressé.

12. Structure de réseaux de neurones selon une des revendications 8 à 11 réalisée sous forme de circuit intégré.

**Patentansprüche**

1. Anordnung aus Datenzellen (P), die mindestens eine Matrix aus in Zeilen und Spalten angeordneten Datenwörtern (M) speichert, wobei die Zeilen oder die Spalten der Matrix in parallele Diagonalen transponiert sind, um selektiven Zugriff durch Adressierung entweder der Zellen einer Zeile oder einer Spalte oder der Zellen einer Diagonalen der Anordnung von Zellen zu ermöglichen, wobei die Matrix in der Anordnung verteilt ist, um auf einem einzigen Bus ($11_1$) mit Hilfe von Mitteln zur Betriebsartselektion (LI, CI) permutierte Datenwörter zu empfangen oder zu liefern, die entweder einer Zeile oder einer Spalte der Matrix entsprechen, dadurch gekennzeichnet, daß jede Datenzelle (P11-P33) mit dem einzigen Bus ($11_1$) über in Reihe geschaltete Schalter (R11, T11) für jede Adressierart verbunden ist, wobei die das Wort einer gleichen Art adressierenden Schalter durch vertikale oder horizontale Steuerleitungen (CI) kontrolliert werden, die die Spalten bzw. Zeilen steuern, und durch diagonale Steuerleitungen (LI), die die Diagonalen steuern, wobei die Schalter durch Aktivieren der vertikalen oder horizontalen Steuerleitungen und einer diagonalen Steuerleitung oder umgekehrt gesteuert werden.

2. Anordnung nach Anspruch 1, dadurch gekennzeichnet, daß jeder Schalter einen Selektionstransistor (T11, R11) umfaßt.

3. Anordnung nach einem der Ansprüche 1 oder 2, dadurch gekennzeichnet, daß die Matrix aus Datenwörtern in der Anordnung diagonal verteilt ist, so daß, wenn eine Zeile (Spalte) der Matrix in der Anordnung diagonal verteilt ist, die anderen Zeilen (anderen Spalten) der Matrix parallel zu dieser Diagonalen verteilt sind.

4. Anordnung nach einem der Ansprüche 1 bis 3, dadurch gekennzeichnet, daß das Anordnen der Daten eines Wortes auf dem Bus (13) mittels eines Umlaufschieberegisters ($12_1$) erfolgt, das von einem Umlaufglied (22) gesteuert wird, das die Daten entsprechend der adressierten Reihe der Matrix verschiebt.

5. Anordnung nach einem der Ansprüche 1 bis 4, dadurch gekennzeichnet, daß das Anordnen der Daten eines Wortes auf dem Bus (36) mittels eines Addierers (31) erfolgt, der eine interne Adresse der Pufferschaltung ($12_1$) bestimmt, indem er

einen zu der adressierten Reihe in der Anordnung gehörenden vorbestimmten Wert einer externen Adresse (35) der Pufferschaltung hinzufügt.

6. Anordnung nach einem der Ansprüche 1 bis 5, dadurch gekennzeichnet, daß mehrere Matrizen aus Datenwörtern in der Anordnung in mehreren Dimensionen (D, E, F) verteilt sind, die mehreren Selektionsarten entsprechen.

7. Anordnung nach einem der Ansprüche 1 bis 6, als integrierte Schaltung realisiert.

8. Schichtstruktur neuronaler Netze mit:
    - Lösungsmitteln (50, 51), um für jede Schicht Ausgangsneuronenzustände i auf der Basis von Eingangsneuronenzuständen j zu bestimmen, die untereinander durch Synapsen verbunden sind,
    - einem Speicher (10) mit Mitteln zum Speichern zu diesen Synapsen gehörender synaptischer Koeffizienten $C_{ij}$,
    - Mitteln zum Lernen und zum Wiederauffrischen der synaptischen Koeffizienten $C_{ij}$,
    - Mitteln (12) zum Speichern der Neuronenzustände,
dadurch gekennzeichnet, daß der Speicher (10) von mindestens einer Zellenanordnung nach einem der Ansprüche 1 bis 2 gebildet ist, die mindestens eine quadratische Matrix aus synaptischen Koeffizienten $C_{ij}$ speichert, die in mindestens einer der Zellenanordnungen verteilt sind, wobei diese eine zweifache Adressierung mit Hilfe der Betriebsartselektionsmittel (L1, C1) und des einzigen Busses ($11_1$) aufweist, so daß ein Wort synaptischer Koeffizienten, das entweder zu einer Zeile oder einer Spalte der quadratischen Matrix gehört, adressiert und auf den einzigen Bus ($11_1$) gebracht werden kann, damit die Struktur neuronaler Netze entweder mit der Matrix aus synaptischen Koeffizienten oder mit der transponierten Matrix Lernphasen durchführt, um den Algorithmus zur Fehlerrückfortpflanzung auszuführen.

9. Struktur neuronaler Netze nach Anspruch 8, dadurch gekennzeichnet, daß die synaptischen Koeffizienten in dem Speicher (10) zweidimensional in diagonaler Weise verteilt sind, so daß eine Zeile (eine Spalte) der Matrix in dem Speicher diagonal verteilt ist, während die anderen Zeilen (anderen Spalten) der Matrix parallel zu der genannten Diagonalen verteilt sind.

10. Struktur neuronaler Netze nach einem der Ansprüche 7 oder 9, dadurch gekennzeichnet, daß die Mittel ($12_1$) zum Speichern der Neuronenzustände ein Umlaufschieberegister umfassen, das den Umlauf der Neuronenzustände ermöglicht, um jeden Neuronenzustand mit seinem synaptischen Koeffizienten zusammenzubringen.

11. Struktur neuronaler Netze nach Anspruch 10, dadurch gekennzeichnet, daß sie einen Adressenberechner (22) umfaßt, der den Umlauf in dem Schieberegister ausführt, indem er der Reihe des adressierten Wortes aus synaptischen Koeffizienten entsprechende Befehle generiert.

12. Struktur neuronaler Netze nach einem der Ansprüche 8 bis 11, als integrierte Schaltung realisiert.

**Claims**

1. An arrangement of data cells (P) which stores at least one matrix (M) of data words which are arranged in rows and columns, the rows or the columns of the matrix being transposed in parallel diagonals so as to enable selective accessing, by addressing, of either the cells of a row or column or the cells of a diagonal of the arrangement of cells, the matrix being distributed in the arrangement in order to deliver/receive, via a single bus ($11_1$) and by means of mode selection means (LI, CI), permuted data words which correspond either to a row or to a column of the matrix, characterized in that each data cell (P11-P33) is connected to the single bus ($11_1$) via switches (R11, T11) which are connected in series and which are associated with each addressing mode, the switches addressing the word of a same mode being controlled by vertical or horizontal control lines (CI) which control the columns and the rows, respectively, and by diagonal control lines (LI) which control the diagonals, the switches being controlled by activating the vertical or horizontal control lines and a diagonal control line or vice versa.

2. An arrangement as claimed in Claim 1, characterized in that each switch comprises a selection transistor (T11, R11).

3. An arrangement as claimed in one of the Claims 1 or 2, characterized in that the matrix of data words is diagonally distributed in the arrangement so that a row (column) of the matrix is diagonally distributed in the arrangement, the other rows (other columns) of the matrix being distributed parallel to said diagonal .

4. An arrangement as claimed in one of the Claims 1 to 3, characterized in that the data of a word are arranged on the bus (13) by a circulation shift register (12) which is controlled by a circulation member (22) which shifts the data as a function of the addressed row of the matrix.

5. An arrangement as claimed in one of the Claims 1 to 4, characterized in that the data of a word are arranged on the bus (36) by an adder (31) which determines an internal address of the buffer circuit (12), by adding a predetermined value, associated with the addressed row in the arrangement, to an external address (35) of the buffer circuit.

6. An arrangement as claimed in one of the Claims 1 to 5, characterized in that several data word matrices are distributed in the arrangement in several dimensions (D, E, F) which correspond to several selection modes.

7. An arrangement as claimed in one of the Claims 1 to 6, realized as an integrated circuit.

8. A layered neural network structure comprising:
   - resolving means (50, 51) for determining, for each layer, states of output neurons i on the basis of states of input neurons j which are interconnected by way of synapses,
   - a memory (10) comprising means for storing synaptic coefficients $C_{ij}$ associated with these synapses,
   - means for learning and for updating the synaptic coefficients $C_{ij}$,
   - means (12) for storing the neuron states,
   characterized in that the memory (10) is formed by at least one arrangement of cells as claimed in one of the Claims I to 2 which stores at least one square matrix of synaptic coefficients $C_{ij}$ which are distributed in at least one of the arrangements of cells with dual addressing by way of the mode selection means (L1, C1) and the single bus ($11_1$) so that a synaptic coefficient word relating either to a row or a column of the square matrix can be addressed and placed on the single bus ($11_1$) in order to enable the neural network structure to execute learning steps either by means of the synaptic coefficient matrix or by means of the transposed matrix in order to execute the error backpropagation algorithm.

9. A neural network structure as claimed in Claim 8, characterized in that the synaptic coefficients are two-dimensionally, diagonally distributed in the memory (10) so that one row (one column) of the matrix is distributed diagonally in the memory, the other rows (other columns) of the matrix being distributed parallel to said diagonal.

10. A neural network structure as claimed in one of the Claims 7 or 9, characterized in that the means ($12_1$) for storing the neuron states comprise a circulation shift register enabling circulation of the neuron states in order to associate each neuron state with its synaptic coefficient.

11. A neural network structure as claimed in Claim 10, characterized in that it comprises an address calculator (22) which performs the circulation in the shift register by generating commands corresponding to the row of the addressed synaptic coefficient word.

12. A neural network structure as claimed in one of the Claims 8 to 11, realized in that the form of an integrated circuit.

**FIG.1**

|  |  | C1 | | C3 | | | | |  |
|---|---|---|---|---|---|---|---|---|---|
| L1 → | 00 | 10 | 20 | 30 | 40 | 50 | 60 | 70 | 20 |
|  | 01 | 11 | 21 | 31 | 41 | 51 | 61 | 71 | 21 |
| L3 → | 02 | 12 | 22 | 32 | 42 | 52 | 62 | 72 | 22 |
|  | 03 | 13 | 23 | 33 | 43 | 53 | 63 | 73 | 23 |
|  | 04 | 14 | 24 | 34 | 44 | 54 | 64 | 74 | 24 |
|  | 05 | 15 | 25 | 35 | 45 | 55 | 65 | 75 | 25 |
|  | 06 | 16 | 26 | 36 | 46 | 56 | 66 | 76 | 26 |
|  | 07 | 17 | 27 | 37 | 47 | 57 | 67 | 77 | 27 |

$12_1$

10

$11_1$

$11_2$

| 02 | 12 | 22 | 32 | 42 | 52 | 62 | 72 |
|---|---|---|---|---|---|---|---|

$12_2$

**FIG.2**

| | C3 | | | | | | | | $12_1$ | |
|---|---|---|---|---|---|---|---|---|---|---|
| 00 | 17 | 26 | 35 | 44 | 53 | 62 | 71 | | 26 | 62 |
| 01 | 10 | 27 | 36 | 45 | 54 | 63 | 72 | | 27 | 72 |
| 02 | 11 | 20 | 37 | 46 | 55 | 64 | 73 | | 20 | 02 |
| 03 | 12 | 21 | 30 | 47 | 56 | 65 | 74 | | 21 | 12 |
| 04 | 13 | 22 | 31 | 40 | 57 | 66 | 75 | | 22 | 22 |
| 05 | 14 | 23 | 32 | 41 | 50 | 67 | 76 | | 23 | 32 |
| 06 | 15 | 24 | 33 | 42 | 51 | 60 | 77 | | 24 | 42 |
| 07 | 16 | 25 | 34 | 43 | 52 | 61 | 70 | | 25 | 52 |

L3 →

10

I   II

FIG.3A

FIG.3B

FIG. 4

FIG.6A

FIG.6B

FIG. 5A

FIG. 5B

FIG. 5C